# EUROPEAN PATENT APPLICATION

(11) **EP 2 477 239 A2**
(43) Date of publication of application: **18.07.2012**
(21) Application number: 12150692.7
(22) Date of filing: 11.01.2012
(51) Int. Cl.: H01L 33/42

(54) **Semiconductor light emitting device**

(30) Priority: 12.01.2011 KR 20110003136
(71) Applicant: Samsung LED Co., Ltd., Yongin-City, Gyeonggi-Do (KR)
(72) Inventor: Kim, Tae Hun, Gyeonggi-do (KR); Choi, Seung Woo, Gyeonggi-do (KR); Jang, Tae Sung, Gyeonggi-do (KR)
(74) Representative: Grünecker, Kinkeldey, Stockmair & Schwanhäusser

(57) **Abstract**

A semiconductor light emitting device is herein disclosed. The semiconductor light emitting device includes: a conductive substrate (11), a p-type semiconductor layer (12) disposed on the conductive substrate, an active layer (13) disposed on the p-type semiconductor layer, an n-type semiconductor layer (14) disposed on the active layer, and an n-side electrode disposed on the n-type semiconductor layer and including a carbon nanotube layer (15) doped with an n-type impurity.

## Description

### CROSS-REFERENCE TO RELATED APPLICATIONS

This application claims the priority of Korean Patent Application No. 10-2011-0003136 filed on January 12, 2011, in the Korean Intellectual Property Office, the disclosure of which is incorporated herein by reference.

### BACKGROUND OF THE INVENTION

### Field of the Invention

The present invention relates to a semiconductor light emitting device.

### Description of the Related Art

In general, a light emitting diode (LED), a kind of semiconductor light source, is a semiconductor device capable of generating light of various colors due to the recombination of electrons and electron holes at the junction between a p-type semiconductor and an n-type semiconductor, when current is applied thereto. Demand for this type of light emitting diode has been continuously increasing, since the light emitting diode has various advantages, such as a long lifespan, low power consumption, superior initial driving characteristics, high vibration resistance, and the like, as compared to a filament-based light source. In particular, a group III-nitride semiconductor capable of emitting blue light having a short wavelength has recently come to prominence.

However, in particular, this light emitting diode has limitations in that the light emitting efficiency thereof is deteriorated due to the concentration of current in a certain area of a light emitting layer. Thus, a method of designing a semiconductor light emitting device having excellent current distribution effects while having high light transmission and electrical conductivity has been required.

### SUMMARY OF THE INVENTION

An aspect of the present invention provides a semiconductor light emitting device having excellent current distribution effects while having high light transmissivity and electrical conductivity.

According to an aspect of the present invention, there is provided a semiconductor light emitting device, including: a conductive substrate; a p-type semiconductor layer disposed on the conductive substrate; an active layer disposed on the p-type semiconductor layer; an n-type semiconductor layer disposed on the active layer; and an n-side electrode disposed on the n-type semiconductor layer and including a carbon nanotube layer doped with an n-type impurity.

The n-side electrode may further include an ohmic metal layer electrically connected with the carbon nanotube layer doped with the n-type impurity.

The ohmic metal layer may be formed in a central area of an upper surface of the carbon nanotube layer.

The ohmic metal layer may be formed in a partial area of an upper surface of the n-type semiconductor layer, and the carbon nanotube layer may be formed on an area of the upper surface of the n-type semiconductor layer, with the exemption of the partial area in which the ohmic metal layer is formed.

The n-type impurity of the carbon nanotube may include at least one of oxygen (O₂) or an alkali metal.

The semiconductor light emitting device may further include a light transmitting conductive layer disposed between the n-type semiconductor layer and the n-side electrode.

The semiconductor light emitting device may further include a passivation layer disposed on the carbon nanotube layer.

The passivation layer may be formed to entirely cover an upper surface of the carbon nanotube layer.

The n-side electrode may further include a fluorescent layer disposed on the carbon nanotube layer.

The carbon nanotube layer may be formed to entirely cover an upper surface of the n-type semiconductor layer.

The the carbon nanotube layer is doped with the n-type impurity by an oxide layer deposited on the carbon nanotube layer.

The oxide layer may include at least one of nitrogen (N), phosphorus (P), arsenic (As), antimony (Sb), and bismuth (Bi).

According to another aspect of the present invention, there is provided a semiconductor light emitting device, including: an n-type semiconductor layer; an active layer and a p-type semiconductor layer sequentially formed on the n-type semiconductor layer; an n-side electrode formed on the n-type semiconductor layer exposed by removing parts of the p-type semiconductor and the active layer; and a p-side electrode formed on the p-type semiconductor layer, wherein the n-side electrode further includes a carbon nanotube layer doped with an n-type impurity.

The n-side electrode may further include an ohmic metal layer electrically connected with the carbon nanotube layer doped with the n-type impurity.

The ohmic metal layer may be formed in a center area of an upper surface of the carbon nanotube layer doped with the n-type impurity.

The ohmic metal layer may be formed in at least a partial area of an upper surface of the n-type semiconductor layer, and the carbon nanotube layer is formed in at least a part of area of the upper surface of the n-type semiconductor layer, with the exemption of the at least the partial area in which the ohmic metal layer is formed.

The semiconductor light emitting device may further include a light transmitting conductive layer disposed between the n-type semiconductor layer and the n-side electrode.

The n-side electrode may further include a fluorescent layer disposed on the carbon nanotube layer.

The p-side electrode may include a carbon nanotube doped with a p-type impurity.

The p-side electrode may further include an ohmic metal layer electrically connected with the carbon nanotube layer doped with the p-type impurity.

The ohmic metal layer may be formed in a center area of an upper surface of the carbon nanotube layer doped with the p-type impurity.

The ohmic metal layer may be formed in at least a partial area of an upper surface of the p-type semiconductor layer, and the carbon nanotube layer may be formed on at least a part of area of the upper surface of the p-type semiconductor layer, with the exemption of the at least the partial area in which the ohmic metal layer is formed.

The semiconductor light emitting device may further include a light transmitting conductive layer disposed between the p-type semiconductor layer and the p-side electrode.

The p-side electrode may further include a fluorescent layer disposed on the carbon nanotube layer.

The semiconductor light emitting device may further include a passivation layer disposed on the carbon nanotube layer.

### BRIEF DESCRIPTION OF THE DRAWINGS

The above and other aspects, features and other advantages of the present invention will be more clearly understood from the following detailed description taken in conjunction with the accompanying drawings, in which:
FIG. 1A is a cross-sectional view of a semiconductor light emitting device according to an exemplary embodiment of the present invention;
FIG. 1B is a plan view of the semiconductor light emitting device according to the exemplary embodiment of the present invention;
FIG. 2 is a cross-sectional view of a semiconductor light emitting device according to an exemplary embodiment of the present invention;
FIG. 3 is a cross-sectional view of a semiconductor light emitting device according to an exemplary embodiment of the present invention;
FIG. 4 is a cross-sectional view of a semiconductor light emitting device according to an exemplary embodiment of the present invention;
FIG. 5 is a cross-sectional view of a semiconductor light emitting device according to an exemplary embodiment of the present invention; and
FIG. 6 is a cross-sectional view of a semiconductor light emitting device according to an exemplary embodiment of the present invention.

### DETAILED DESCRIPTION OF THE PREFERRED EMBODIMENT

Exemplary embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and sizes of components are exaggerated for clarity. While those skilled in the art could readily devise many other varied embodiments that incorporate the teachings of the present invention through the addition, modification or deletion of elements, such embodiments may fall within the scope of the present invention. The same or equivalent elements are referred to by the same reference numerals throughout the specification.

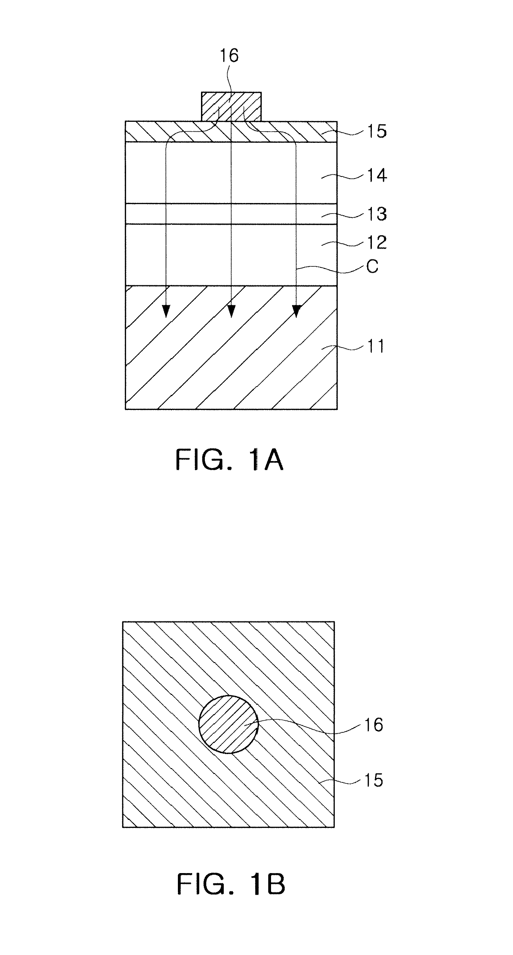

FIGS. 1A and 1B respectively show a semiconductor light emitting device according to an exemplary embodiment of the present invention. Here, FIG. 1A is a cross-sectional view of the semiconductor light emitting device and FIG. 1B is a plan view of the semiconductor light emitting device according to an exemplary embodiment of the present invention.

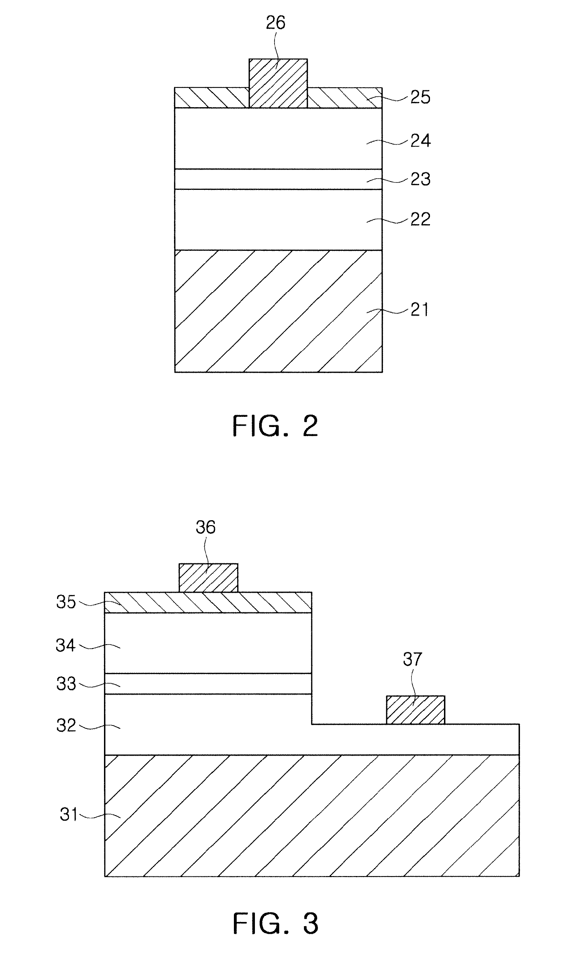

Referring to FIGS. 1 and 2, the semiconductor light emitting device according to the exemplary embodiment of the present invention may be configured to include a light emitting structure formed by sequentially stacking a p-type semiconductor layer 12, an active layer 13, and an n-type semiconductor layer 14 on a substrate 11, a carbon nanotube layer 15 formed on the n-type semiconductor layer 14, the carbon nanotube layer being doped with an n-type impurity, and an ohmic metal layer 16 disposed on the carbon nanotube layer 15.

In this case, as the process of stacking the light emitting structure on the substrate, a process well known in the art may be used. For example, the n-type semiconductor layer 14, the active layer 13, and the p-type semiconductor layer 12 may be sequentially grown on a substrate for growing an nitride single crystal (not shown), such as a sapphire substrate, and then the substrate 11, having conductivity (hereinafter, referred to as a 'conductive substrate'), corresponding to a supporting substrate, may be formed on the p-type semiconductor layer 12, and the sapphire substrate may be removed. By doing so, light generated from the active layer 13 may generally be emitted in a direction of the n-type semiconductor layer 14. Thereafter, the process of forming the carbon nanotube layer 15 doped with the n-type impurity may be provided.

Hereinafter, components constituting the semiconductor light emitting device will be explained in detail with reference to FIGS. 1A and 1B.

The conductive substrate 11 may support a light emitting stacked body having a relatively thin thickness during a process, such as the removing of a substrate for growing a single crystal (hereinafter, referred to as 'a growth substrateʹ), or the like. Further, according to embodiments of the present invention, the conductive substrate 11 may be provided as a bonding part bonded with a printed circuit board (PCB) or the like by using a conductive adhesive layer (not shown) to thereby act as a p-side electrode. In addition, the conductive substrate 11 may be formed to be combined with the light emitting stacked body by using a plating or wafer bonding method, and may have excellent electrical conductivity and thermal conductivity. High thermal conductivity may allow for the easy emission of heat generated during an operation, whereby the reliability and lifespan of the device may be enhanced.

The conductive substrate 11 may function to transmit an electrical signal to the p-type semiconductor layer 12, as well as act as a support supporting the light emitting structure during the process of removing the growth substrate, such as a laser lift-off process or the like. To this end, the conductive substrate 11 may be made of a material including any one of gold (Au), nickel (Ni), aluminum (Al), copper (Cu), Tungsten (W), silicon (Si), selenium (Se), and gallium arsenide (GaAs), and may be a Si substrate doped with Al, for example. In the exemplary embodiment of the present invention, the conductive substrate 11 may be bonded with the light emitting structure by using the conductive adhesive layer (not shown) and may be plated.

The n-type and p-type nitride semiconductor layers 14 and 12 may be made of a semiconductor material doped with an n-type impurity and a p-type impurity having a composition formula of AlxInyGa(1-x-y)N (Here, 0≤x≤1, 0≤y≤1, 0≤x+y≤1). For example, as the semiconductor material, gallium nitride (GaN), aluminium gallium nitride (AlGaN), or indium gallium nitride (InGaN) may be used. As the n-type impurity, silicon (Si), germanium (Ge), selenium (Se), tellurium (Te), or carbon (C) may be used and as the p-type impurity, magnesium (Mg), zinc (Zn) or beryllium (Be) may be used.

The active layer 13 may be configured as an undoped nitride semiconductor layer having a single or multiple quantum well structure, and may emit light having a predetermined level of energy by the recombination of electrons and electron holes.

In this case, the n-type and p-type nitride semiconductor layers 14 and 12, and the active layer 13 may be grown by various methods, such as metal organic chemical vapor deposition (MOCVD), molecular beam epitaxy (MBE), hydride vapor phase epitaxy (HVPE) or the like.

N-side electrodes 15 and 16 may include the carbon nanotube layer 15 doped with the n-type impurity, and the n-side ohmic metal layer 16 may be disposed on the carbon nanotube layer 15.

Here, the carbon nanotube has a tube shape in which one carbon atom is combined with another carbon atom in such a manner as to have a hexagonal honeycomb pattern. The diameter of the tube may reach several to several tens of nanometers. In addition, as the carbon nanotube has high electrical conductivity and thermal conductivity and may have rigidity higher than that of a diamond, the carbon nanotube may be widely used as a material in the field of the hi-tech electronics industry in addition to a conventional material.

Meanwhile, the carbon nanotube may have a structure in which single-walled carbon nanotubes (SWNTs) made of a single tube, double-walled carbon nanotubes (DWNTs) having two tubes overlapped with each other, or multi-walled carbon nanotubes (MWNTs) are formed. In addition, as the carbon nanotube, any one kind of a metal-carbon nanotube, a polymer-carbon nanotube, and a liquid-carbon nanotube may be used. Such a carbon nanotube may be synthesized by using plasma-enhanced chemical vapor deposition (PECVD). Through the PECVD process, the carbon nanotube may be synthesized at a relatively low temperature and may be selectively grown. Thus, the PECVD may be suitable in the case of growing the carbon nanotube directly on the support. As a concrete method for the PECVD, a metal such as iron (Fe), nickel (Ni), Co (cobalt) or the like is deposited in a chamber by a sputtering method, thereby forming a catalytic metal layer (not shown) . Then, the catalytic metal layer is etched by using ammonia, a hydrogen gas and the like, thereby being a catalytic metal layer having a nano-sized fine pattern. In this case, the particle size and density of the catalytic metal layer may be controlled by controlling etching time. Thereafter, in order to synthesize the carbon nanotube, through the application of a high frequency power supply in a state in which a reactant gas made of at least one of acetylene (C2H2), methane (CH4), ethylene (C2H4), propylene (C3H6), propane (C3H8) and carbon monoxide (CO) is supplied, carbon nanotubes may be vertically aligned to be grown on the catalytic metal layer having the fine pattern. In this case, the size of the pattern formed by the carbon nanotube may be controlled by controlling etching time.

In addition, the carbon nanotube layer may be formed by using various methods, for example, a screen printing method using a paste, a spray method, or the like, in addition to the PECVD. The spray method may be advantageous in that the carbon nanotubes may be dispersed in a solvent, such as ethanol or the like, thereby fabricating a dispersion solution, and the dispersion solution may be sprayed on, for example, a silicon substrate to be thermally treated (for example, thermal treatment at approximately 80 °C) in a subsequent process, thereby forming the carbon nanotube layer.

The carbon nanotube layer formed as above may naturally have p-type semiconductor characteristics, while the carbon nanotube layer may be doped with oxygen (O2) or an alkali metal, for example, potassium, thereby obtaining the n-type carbon nanotube 15.

In addition, the n-type carbon nanotube 15 may be obtained by depositing an oxidation layer on the carbon nanotube having the p-type semiconductor characteristics. The oxidation layer may be formed by depositing a bismuth titanium silicon oxide (BTSO) through an atomic layer deposition (ALD) process at 300□. In this case, water vapor may be used as an oxygen source. In this manner, when the BTSO is deposited, a carbon nanotube 32 is doped with the n-type impurity while an electron of a bismuth layer is adhered to the surface of the carbon nanotube layer. In this case, an n-type doping process may be simplified and facilitated.

Meanwhile, an oxide layer may be formed as an oxidation layer as above; however, it is not limited thereto. The oxidation layer may formed of a layer including any one atomic layer of nitrogen (N), phosphorus (P), arsenic (As), antimony (Sb), and bismuth (Bi).

In this case, the carbon nanotube 15 may be formed to entirely cover the upper surface of the n-type semiconductor layer 14, and the ohmic metal layer 16 may be formed in the center portion of the carbon nanotube layer 15. By disposing the ohmic metal layer 16 in this manner, as shown in FIG.1A, current flow C across the light emitting structure may have symmetry over the entire semiconductor light emitting device, whereby current distribution may be more effectively performed.

Although not illustrated, a highly reflective ohmic contact layer may be formed as a p-side electrode on the conductive substrate 11. The highly reflective ohmic contact layer may form an ohmic contact with the p-type semiconductor layer 12, and may be formed to have reflectivity of 70% or more. In addition, the highly reflective ohmic contact layer may include at least one layer made of a material selected from a group consisting of Ag, Ni, Al, Rh, Pd, Ir, Ru, Mg, Zn, Pt, Au and a mixture thereof. The highly reflective ohmic contact layer may be made of Ni/Ag, Zn/Ag, Ni/Al, Ni/Au, Zn/Al, Pd/Ag, Pd/Al, Ir/Ag. Ir/Au, Pt/Ag, Pt/Al or Ni/Ag/Pt. However, the highly reflective ohmic contact layer is not an essential element in exemplary embodiments of the present invention, and may be selectively employed and variously modified according to the exemplary embodiments of the present invention.

FIG. 2 is a cross-sectional view of a semiconductor light emitting device according to an exemplary embodiment of the present invention.

Referring to FIG.2, the semiconductor light emitting device according to the exemplary embodiment of the present invention is different from the semiconductor light emitting device of FIG. 1, in that an ohmic metal layer 26 is directly formed on an n-type semiconductor layer 24, without being formed on a carbon nanotube layer 25. That is, the ohmic metal layer 26 is formed on a partial area of an upper surface of the n-type semiconductor layer 24, and the carbon nanotube layer 25 may be formed on the upper surface of the n-type semiconductor layer 24, with the exemption of the partial area in which the ohmic metal layer 26 is formed.

In this manner, the shape of n-side electrode is not necessarily limited to the shape as shown in FIGS. 1A and 1B, and may be modified by variously changing the shapes of the ohmic metal layer 26 and the carbon nanotube layer 25 so as to be suitable to individual exemplary embodiments of the present invention.

FIG. 3 is a cross-sectional view of a semiconductor light emitting device according to an exemplary embodiment of the present invention.

Referring to FIG. 3, according to the exemplary embodiment of the present invention, the semiconductor light emitting device may be provided in such a manner that a part of a light emitting structure is removed such that a p-type semiconductor layer 32 is exposed to the outside, a p-side ohmic metal layer 37 is formed on the exposed p-type semiconductor 32, and finally the n-side and p-side electrodes are towards the same direction.

In this manner, the shapes of the n-side and p-side electrodes are not necessarily limited to shapes shown in FIG. 1A and 1B, and may also be applied to a light emitting device structure in which current flow is made in a horizontal direction, rather than a vertical direction.

Although not illustrated, at least one of the n-type and p-type electrodes may be provided to include an ohmic metal layer electrically connected with the carbon nanotube layer doped with the n-type or p-type impurity. In this case, the ohmic metal layer may be formed in the central area of the upper surface of the carbon nanotube layer, or may be formed in a partial area of the upper surface of the n-type and p-type semiconductor layers. The carbon nanotube layer may be formed on the upper surface of the n-type and p-type semiconductor layers, with the exemption of the partial area in which the ohmic metal layer is formed.

In addition, a light transmitting conductive layer may be disposed between the n-type semiconductor layer and the n-side electrode, and the p-type semiconductor layer and the p-side electrode, or a passivation may be provided on the carbon nanotube layer, and a fluorescent layer may be disposed on the carbon nanotube layer.

In this case, as described above, since the carbon nanotube may naturally have p-type characteristics, the semiconductor light emitting device may be formed by using a p-type carbon nanotube layer.

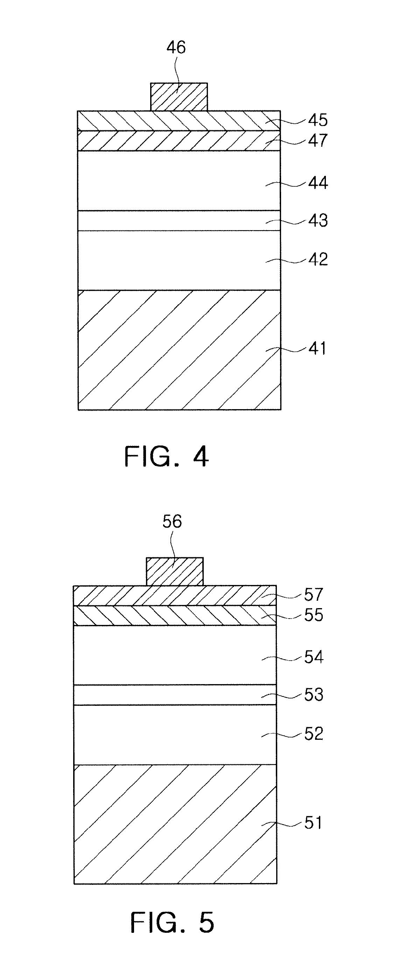

FIG. 4 is a cross-sectional view of a semiconductor light emitting device according to an exemplary embodiment of the present invention.

Referring to FIG. 4, a light transmitting conductive layer 47 may be formed between an n-type semiconductor layer 44 and a carbon nanotube layer 45. In this case, the light transmitting conductive layer 47 may be formed of an oxide having high light transmittance, preferably indium tin oxide (ITO); however, it is not necessarily limited thereto.

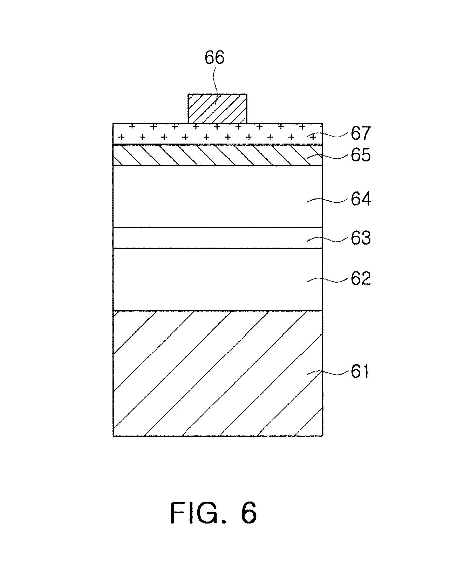

FIG. 5 is a cross-sectional view of a semiconductor light emitting device according to an exemplary embodiment of the present invention and FIG. 6 is a cross-sectional view of a semiconductor light emitting device according to an exemplary embodiment of the present invention.

Referring to FIGS. 5 and 6, at least one of a passivation layer 57 and a fluorescent layer 67 may be provided between carbon nanotube layers 55 and 65, and n-type ohmic metal layers 55 and 66.

The passivation layer 57 which functions to protect a light emitting structure may be formed on the carbon nanotube layer 55 by a chemical surface treatment, and may be formed over the entire upper surface of the carbon nanotube layer 55. In addition, for example, the passivation layer 57 may be formed on the carbon nanotube layer 55 as a selenium compound layer by using an aqueous solution containing selenium therein. The passivation layer 57 may be made of a silicon oxide, such as silicon dioxide (SiO2), SiOxNy, SixNy, or the like or a silicon nitride, and have a thickness of approximately 0.1 to 2 *µ*m.

Furthermore, the fluorescent layer 67 may include at least one of a red fluorescent substance, a green fluorescent substance, and a yellow fluorescent substance to be dispersed in a resin, thereby converting the chromaticity of light generated from the active layer 63, and preferably allowing for the emission of white light.

As set forth above, according to exemplary embodiments of the invention, the semiconductor light emitting device having high transmissivity and electrical conductivity while having excellent current distribution effects may be obtained by forming an electrode as the carbon nanotube layer.

While the present invention has been shown and described in connection with the exemplary embodiments, it will be apparent to those skilled in the art that modifications and variations can be made without departing from the spirit and scope of the invention as defined by the appended claims.

## Claims

1. A semiconductor light emitting device, comprising:
a conductive substrate;
a p-type semiconductor layer disposed on the conductive substrate;
an active layer disposed on the p-type semiconductor layer;
an n-type semiconductor layer disposed on the active layer; and
an n-side electrode disposed on the n-type semiconductor layer and including a carbon nanotube layer doped with an n-type impurity.

2. The semiconductor light emitting device of claim 1, wherein the n-side electrode further includes an ohmic metal layer electrically connected with the carbon nanotube layer doped with the n-type impurity.

3. The semiconductor light emitting device of claim 2, wherein the ohmic metal layer is formed in a central area of an upper surface of the carbon nanotube layer.

4. The semiconductor light emitting device of claim 2, wherein the ohmic metal layer is formed in a partial area of an upper surface of the n-type semiconductor layer, and the carbon nanotube layer is formed on an area of the upper surface of the n-type semiconductor layer, with the exemption of the partial area in which the ohmic metal layer is formed.

5. The semiconductor light emitting device of claim 1, wherein the n-type impurity of the carbon nanotube includes at least one of oxygen (O₂) or an alkali metal.

6. The semiconductor light emitting device of claim 1, wherein the carbon nanotube layer is doped with the n-type impurity by an oxide layer deposited on the carbon nanotube layer.

7. The semiconductor light emitting device of claim 6, wherein the oxide layer includes at least one of nitrogen (N), phosphorus (P), arsenic (As), antimony (Sb), and bismuth (Bi).

8. A semiconductor light emitting device, comprising:
an n-type semiconductor layer;
an active layer and a p-type semiconductor layer sequentially formed on the n-type semiconductor layer;
an n-side electrode formed on the n-type semiconductor layer exposed by removing parts of the p-type semiconductor and the active layer; and
a p-side electrode formed on the p-type semiconductor layer,
wherein the n-side electrode further includes a carbon nanotube layer doped with an n-type impurity.

9. The semiconductor light emitting device of claim 8, wherein the n-side electrode further includes an ohmic metal layer electrically connected with the carbon nanotube layer doped with the n-type impurity.

10. The semiconductor light emitting device of claim 9, wherein the ohmic metal layer is formed in a center area of an upper surface of the carbon nanotube layer doped with the n-type impurity.

11. The semiconductor light emitting device of claim 9, wherein the ohmic metal layer is formed in at least a partial area of an upper surface of the n-type semiconductor layer, and the carbon nanotube layer is formed in at least a part of area of the upper surface of the n-type semiconductor layer, with the exemption of the at least the partial area in which the ohmic metal layer is formed.

12. The semiconductor light emitting device of claim 8, Wherein the p-side electrode includes a carbon nanotube doped with a p-type impurity.

13. The semiconductor light emitting device of claim 12, wherein the p-side electrode further includes an ohmic metal layer electrically connected with the carbon nanotube layer doped with the p-type impurity.

14. The semiconductor light emitting device of claim 13, wherein the ohmic metal layer is formed in a center area of an upper surface of the carbon nanotube layer doped with the p-type impurity.

15. The semiconductor light emitting device of claim 13, wherein the ohmic metal layer is formed in at least a partial area of an upper surface of the p-type semiconductor layer, and the carbon nanotube layer is formed on at least a part of area of the upper surface of the p-type semiconductor layer, with the exemption of the at least the partial area in which the ohmic metal layer is formed.
